# EUROPÄISCHE PATENTANMELDUNG

(11) **EP 1 906 448 A1**
(43) Veröffentlichungstag der Anmeldung: **02.04.2008**
(21) Anmeldenummer: 06020636.4
(22) Anmeldetag: 29.09.2006
(51) Int. Cl.: H01L 23/62

(54) **Abgesichertes Feldeffekttransistorbauelement**

(71) Anmelder: Delphi Technologies, Inc., Troy, Michigan 48007 (US)
(72) Erfinder: Hold, Klaus, 42897 Remscheid (DE); Sohn, Marc, 71139 Ehningen (DE)
(74) Vertreter: Manitz, Finsterwald & Partner GbR

(57) **Zusammenfassung**

Die Erfindung betrifft ein Feldeffekttransistorbauelement mit einem Feldeffekttransistor und zumindest einem reaktiven Element. Das reaktive Element lässt sich im Falle eines Ausfalls des Feldeffekttransistors aktivieren, um das Feldeffekttransistorbauelement gezielt zumindest teilweise zu zerstören.

## Beschreibung

Die vorliegende Erfindung betrifft im Allgemeinen das technische Gebiet der Halbleitertechnik. Insbesondere betrifft die Erfindung ein Feldeffekttransistorbauelement, welches derart eingerichtet ist, dass es sich im Falle eines Ausfalls gezielt zumindest teilweise zerstören lässt.

Feldeffekttransistoren werden beispielsweise eingesetzt, um einen Verbraucher- bzw. Kollektorstrom zwischen dem Drain- und dem Source-Anschluss zu steuern, was über eine Veränderung der am Gate-Anschluss anliegenden Spannung erfolgen kann. Auf diese Weise lässt sich die Stromzufuhr zu einem mit dem Drain- und dem Source-Anschluss verbundenen elektrischen Verbraucher steuern.

Falls jedoch beispielsweise die am Gate-Anschluss anliegende Steuerspannung einen bestimmten Grenzwert überschreitet, kann dies dazu führen, dass der Transistor in einen dauerhaft leitenden Zustand übergeht, in welchem sich der Kollektorstrom nicht mehr steuern lässt. Ein derartiger Zustand, in dem sich der Kollektorstrom nicht mehr steuern lässt, da sich der Feldeffekttransistor in einem dauerhaft leitenden Zustand befindet, wird im Rahmen der vorliegenden Erfindung fortan auch als "Ausfall" bezeichnet.

Wenn ein Feldeffekttransistor in der zuvor angesprochenen Art und Weise ausfällt, kann dies dazu führen, dass sich der Feldeffekttransistor überhitzt. So sind beispielsweise in einem Kraftfahrzeug sehr viele Feldeffekttransistoren verbaut, mit denen die Verbraucherströme einzelner elektrischer Verbraucher des Kraftfahrzeugs gesteuert werden. Im Falle, dass sich der Verbraucherstrom eines solchen Feldeffekttransistors nicht mehr steuern lässt, da dieser in seinen dauerhaft leitenden Zustand übergegangen ist, zieht der an dem Feldeffekttransistor angeschlossene Verbraucher unter Umständen kontinuierlich einen Verbraucherstrom, was zu der genannten Überhitzung führen kann.

Der vorliegenden Erfindung liegt daher die Aufgabe zugrunde, ein Feldeffekttransistorbauelement anzugeben, welches sich im Falle eines Ausfalls nicht übermäßig erhitzt.

Die der Erfindung zugrunde liegende Aufgabe wird mit einem Feldeffekttransistorbauelement gelöst, welches die Merkmale des Anspruchs 1 aufweist. Die Lösung der Aufgabe erfolgt insbesondere dadurch, dass das Feldeffekttransistorbauelement ein reaktives Element umfasst, welches sich im Falle eines Ausfalls des Feldeffekttransistors aktivieren lässt, so dass dadurch das Feldeffekttransistorbauelement gezielt zumindest teilweise zerstört wird.

Die gezielte Zerstörung des Feldeffekttransistorbauelements sollte dabei so vonstatten gehen, dass dieses durch die zumindest teilweise Zerstörung in einen Leerlaufzustand übergeht, in dem zwischen dem Drain- und dem Source-Anschluss kein Kollektorstrom mehr fließt. Auf diese Weise kann sichergestellt werden, dass, wenn das Feldeffekttransistorbauelement dauerhaft leitend geworden ist, keine Überhitzungserscheinungen auftreten können, welche ansonsten als Ausgangspunkt für Folgereaktionen dienen könnten.

Durch die Aktivierung des reaktiven Elements wird das erfindungsgemäße Feldeffekttransistorbauelement somit in einen abgesicherten Zustand überführt, in welchem von dem Feldeffekttransistorbauelement keinerlei Gefahr mehr ausgeht. Zwar wird durch die Aktivierung des reaktiven Elements das Feldeffekttransistorbauelement (zumindest teilweise) zerstört, jedoch kann dies ohne weiteres in Kauf genommen werden, da im Falle eines Ausfalls das Feldeffekttransistorbauelement bereits ohnehin nicht mehr funktionsfähig, da dauerhaft leitend, ist. Zum anderen lassen sich unter Umständen durch eine derartige absichtliche Zerstörung des Feldeffekttransistorbauelements größere Schäden verhindern.

Das reaktive Element kann beispielsweise ein pyrotechnisches Element umfassen, welches sich durch Zufuhr von Energie entzündet. Anstelle eines derartigen pyrotechnischen Elements kann das reaktive Element beispielsweise auch eine chemisch reaktive Substanz oder eine reagierende Flüssigkeit umfassen, welche durch Energiezufuhr das Feldeffekttransistorbauelement zumindest soweit schädigt, dass einem an das Feldeffekttransistorbauelement angeschlossenen Verbraucher kein Verbraucherstrom mehr zur Verfügung gestellt werden kann. Durch ein derartiges reaktives Element in Form eines pyrotechnischen Elements oder/und auch in Form einer chemisch reaktiven Substanz lässt sich das erfindungsgemäße Feldeffekttransistorbauelement durch einen nur geringen Energieeintrag zerstören, da, sobald die Aktivierung des reaktiven Elements durch den Energieeintrag angestoßen wurde, die weitere Zerstörungsreaktion in Form einer Kettenreaktion selbsttätig weiter vonstatten geht. Es bedarf somit lediglich eines kurzzeitigen gezielten Energieeintrags in das reaktive Element, um das Feldeffekttransistorbauelement in der gewünschten Weise zumindest teilweise zu zerstören.

Um das reaktive Element vor einer zufälligen Aktivierung, beispielsweise durch externe Wärmequellen, zu schützen, kann das reaktive Element in das Gehäuse des Feldeffekttransistorbauelements mit eingelassen sein. Das reaktive Element kann somit bereits während der Einhausung des Feldeffekttransistors selbst mit in das Gehäuse aus beispielsweise Polyamid eingespritzt werden, so dass sich die Herstellung des erfindungsgemäßen Feldeffekttransistorbauelements nur geringfügig aufwendiger gestaltet. Das reaktive Element kann dabei an beliebiger Stelle im Inneren des Gehäuses des Feldeffekttransistorbauelements lokalisiert sein, sofern durch diese Lage sichergestellt ist, dass im Falle einer Aktivierung des reaktiven Elements das Feldeffekttransistorbauelement zumindest soweit zerstört wird, dass einem daran angeschlossenen elektrischen Verbraucher danach kein Verbraucherstrom mehr über den Drain- und den Source-Anschluss zur Verfügung gestellt werden kann.

So ist das reaktive Element gemäß einer besonderen Ausführungsform des erfindungsgemäßen Feldeffekttransistorbauelements derart innerhalb des Gehäuses lokalisiert, dass durch dessen Aktivierung die Verbindung zwischen zumindest einem Anschlusspin des Feldeffekttransistorbauelements und dem Feldeffekttransistor selbst unterbrochen wird. Auch kann das reaktive Element so angeordnet sein, dass im Falle einer Aktivierung desselben die Verbindung zwischen der Drain-Elektrode des Feldeffekttransistors und dem zugehörigen Anschlusspin und/oder die Verbindung zwischen der Source-Elektrode und dem zugehörigen Anschlusspin unterbrochen wird. Auf diese Weise kann zuverlässig sichergestellt werden, dass nach der Aktivierung des reaktiven Elements das Feldeffekttransistorbauelement soweit geschädigt ist, dass einem daran angeschlossenen elektrischen Verbraucher kein Verbraucherstrom mehr zur Verfügung gestellt werden kann.

Besonders zuverlässig lässt sich das erfindungsgemäße Feldeffekttransistorbauelement zerstören, indem das reaktive Element im Verlauf zumindest einer Verbindung zwischen dem Feldeffekttransistor und einem Anschlusspin des Feldeffekttransistorbauelements angeordnet ist. Zwar kann es ausreichend sein, das reaktive Element an beliebiger Stelle im Inneren des Gehäuses zu lokalisieren, sofern dadurch sichergestellt ist, dass durch dessen Aktivierung die Verbindung zwischen zumindest einem Anschlusspin und dem Feldeffekttransistor selbst unterbrochen wird. Vorteilhaft ist es jedoch, das reaktive Element direkt im Verlauf zumindest einer Verbindungsleitung zwischen dem Feldeffekttransistor und einem Anschlusspin des Feldeffekttransistorbauelements anzuordnen, da in diesem Falle eine Bereitstellung eines Verbraucherstroms nach der Aktivierung des reaktiven Elements mit noch größerer Wahrscheinlichkeit ausgeschlossen ist.

Wie bereits zuvor erwähnt, umfasst das erfindungsgemäße Feldeffekttransistorbauelement zumindest ein reaktives Element, was impliziert, dass mehrere reaktive Elemente vorgesehen sein können. Sofern daher hier davon die Rede ist, dass im Verlauf zumindest einer Verbindung zwischen dem Feldeffekttransistor und einem Anschlusspin das reaktive Element angeordnet ist, so kann dies bedeuten, dass in mehreren Verbindungen, welche innerhalb des Gehäuses des Feldeffekttransistorbauelements zwischen dem Feldeffekttransistor selbst und den zugehörigen Anschlusspins vorgesehen sind, reaktive Elemente platziert sind.

Gemäß einer weiteren besonders zuverlässigen Ausführungsform des erfindungsgemäßen Feldeffekttransistorbauelements kann somit beispielsweise im Verlauf der Verbindung zwischen dem Drain-Anschluss des Feldeffekttransistors und dem zugehörigen Anschlusspin ein reaktives Element angeordnet sein. Alternativ oder in Ergänzung dazu kann jedoch auch ein reaktives Element im Verlauf der Verbindung zwischen dem Source-Anschluss des Feldeffekttransistors und dem zugehörigen Anschlusspin angeordnet sein. Durch eine derartige serielle Schaltung der reaktiven Elemente im Verlauf der genannten Anschlüsse kann somit sehr zuverlässig sichergestellt werden, dass nach einer Aktivierung der reaktiven Elemente einem an das Feldeffekttransistorbauelement angeschlossenen elektrischen Verbraucher kein Verbraucherstrom mehr zur Verfügung gestellt werden kann.

Sofern die Verbindungen zwischen dem Drain-Anschluss und dem zugehörigen Anschlusspin sowie dem Source-Anschluss und dem zugehörigen Anschlusspin entsprechend nahe beieinander verlaufen und das reaktive Element eine ausreichende Größe aufweist, kann es ausreichend sein, nur ein reaktives Element vorzusehen, welches sich im Verlauf der beiden genannten Drain- bzw. Source-Anschlussverbindungen befindet und die beiden genannten Verbindungen somit gewissermaßen reaktiv miteinander koppelt, so dass sowohl über den Anschlusspin des Drain-Anschlusses als auch über den Anschlusspin des Source-Anschlusses ein geeigneter Energieeintrag zur Aktivierung des reaktiven Elements vorgenommen kann.

Um einen Energieeintrag zur Aktivierung des zumindest einen reaktiven Elements über jeden beliebigen Anschlusspin vornehmen zu können, kann im Verlauf sämtlicher Verbindungen zwischen dem Feldeffekttransistor und den zugehörigen Anschlusspins des Feldeffekttransistorbauelements ein eigenes reaktives Element angeordnet sein, so dass durch einen entsprechenden Energieeintrag das Feldeffekttransistorbauelement gezielt zerstört werden kann. Alternativ kann jedoch auch ein einziges größeres reaktives Element vorgesehen werden, welches entsprechend der vorstehend beschriebenen Art und Weise sämtliche oder zumindest einige Verbindungen zwischen dem Feldeffekttransistor und den zugehörigen Anschlusspins reaktiv miteinander koppelt, so dass durch einen externen Energieeintrag über einen beliebigen Anschlusspin das in diesem Fall größere reaktive Element aktiviert und damit das Feldeffekttransistorbauelement zerstört werden kann, um einer weiteren Bereitstellung eines Verbraucherstroms vorzubeugen.

Wie den voranstehenden Passagen entnommen werden kann, ist das zumindest eine reaktive Element eingerichtet, um durch einen externen Energieeintrag aktiviert zu werden. Unter einem externen Energieeintrag ist hierbei beispielsweise eine Bestromung des reaktiven Elements über zumindest einen Anschlusspin des Feldeffekttransistorbauelements zu verstehen, wobei dieser Strom in dem reaktiven Element selbst beispielsweise in Wärme umgesetzt wird, wodurch die bereits zuvor erwähnte Kettenreaktion ausgelöst wird.

Im Gegensatz zu der soeben beschriebenen Aktivierung des reaktiven Elements mittels eines externen Energieeintrags kann das zumindest eine reaktive Element eingerichtet sein, um im Falle eines Ausfalls des Feldeffekttransistorbauelements durch die dabei frei werdende Wärmeenergie selbst und damit gewissermaßen selbsttätig aktiviert zu werden. In diesem Falle muss das Feldeffekttransistorbauelement nicht extern überwacht und mit einem entsprechenden Energieeintrag beaufschlagt werden, um in den gesicherten Zustand überführt zu werden. Vielmehr erfolgt die Überführung des Feldeffekttransistorbauelements in dem gesicherten Zustand allein dadurch, dass im Falle, dass der Feldeffekttransistor dauerhaft leitend geworden ist, sich das Feldeffekttransistorbauelement durch den von einem daran angeschlossenen elektrischen Verbraucher gezogenen Strom auf Dauer so stark erwärmt, dass allein durch die dabei frei werdende Wärmeentwicklung die Aktivierung des reaktiven Elements erfolgt. Es bedarf somit keiner zusätzlicher Steuerungs- und Überwachungsvorrichtungen, so dass im Falle, dass die Aktivierung des reaktiven Elements allein durch die im Falle eines Ausfalls des Feldeffekttransistorbauelements frei werdende Wärmeenergie erfolgt, ein besonders einfach aufgebautes und fehlerunanfälliges Feldeffekttransistorbauelement zur Verfügung stellen lässt, welches einen gesicherten Zustand besitzt.

In voranstehenden Passagen wurde die vorliegende Erfindung allgemeingültig für jede beliebige Art von Feldeffekttransistoren beschrieben. Insbesondere lässt sich die Erfindung jedoch bei Feldeffekttransistoren aus der Gruppe von Feldeffekttransistoren bestehend aus CMOSFETs, MOSFETs, MESFETs, HEMTs, ISFETs, OFETs und JFETs realisieren.

Im Folgenden wird die Erfindung unter Bezugnahme auf die beigefügte Figur näher erläutert. An dieser Stelle sei betont, dass die in der Figur dargestellte Ausführungsform lediglich zu Erläuterungszwecken dient und insbesondere nicht als den Schutzbereich einschränkend aufgefasst werden darf, wobei:

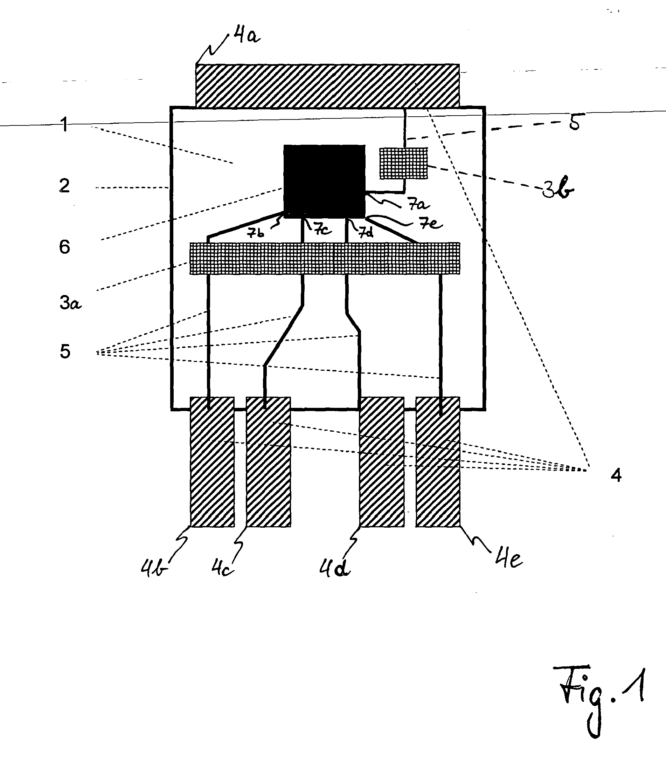

- Fig. 1: eine schematische Darstellung eines erfindungsgemäßen Feldeffekttransistorbauelements zeigt.

Die Fig. 1 zeigt in einer schematischen Darstellung das erfindungsgemäße Feldeffekttransistorbauelement 2, welches neben einem Feldeffekttransistor 6 in Form eines MOSFETs als wesentliche Bestandteile ein erstes pyrotechnisches Element 3a und ein zweites pyrotechnisches Element 3b auf weist. In dem hier beschriebenen Ausführungsbeispiel weist das Feldeffekttransistorbauelement 2 die beiden pyrotechnischen Element 3a und 3b auf, jedoch können selbstverständlich auch andere reaktive Elemente wie beispielsweise chemisch reaktive Substanzen oder reagierende Flüssigkeiten zum Einsatz kommen. Der Feldeffekttransistor 6 sowie die beiden pyrotechnischen Elemente 3a und 3b sind gemeinsam in ein Gehäuse 1 des Feldeffekttransistorbauelements 2 aus beispielsweise Polyamid eingespritzt. Der Feldeffekttransistor 6 weist fünf Anschlusselektroden 7a, 7b, 7c, 7d, 7e auf, welche über gebondete Verbindungsleitungen 5 mit entsprechend zugehörigen, von dem Gehäuse 1 abstehenden Anschlusspins 4 verbunden sind. Insofern handelt es sich bei den Anschlusspins 4a bis 4e um auf die Gehäuseaußenseite verlegte Transistoranschlüsse, welche mit den genannten Anschlüssen 7a bis 7e über gebondete Verbindungsleitungen 5 in elektrischer Wirkverbindung stehen.

Die Belegung der Anschlüsse 7a bis 7e des Feldeffekttransistors 6 ist wie folgt:
- Anschluss 7a: Source
- Anschluss 7b: Ground
- Anschluss 7c: Gate
- Anschluss 7d: Sense
- Anschluss 7e: Drain

Wie der Darstellung der Fig. 1 entnommen werden kann, ist das pyrotechnische Element 3b im Verlauf der Verbindungsleitung 5 zwischen dem Anschlusspin 4a und dem Transistoranschluss 7 platziert. In entsprechender Weise ist im Verlauf der Verbindungsleitungen 5 zwischen den Anschlusspins 4b, 4c, 4d und 4e und den zugehörigen Transistoranschlüssen 7b, 7c, 7d, 7e das pyrotechnische Element 3a angeordnet, welches jedoch im Unterschied zu dem pyrotechnischen Element 3b so große Dimensionen aufweist, dass durch das pyrotechnische Element 3a selbst die vier gebondeten Verbindungsleitungen 5 zwischen den Anschlusspins 4b bis 4e und den zugehörigen Transistoranschlüssen 7b bis 7e in reaktiver Verbindung miteinander stehen.

In gewohnter Weise kann an die Anschlusspins 4a (Source) und 4e (Drain) ein elektrischer Verbraucher angeschlossen werden, um den von diesem Verbraucher gezogenen Verbraucherstrom über den Feldeffekttransistor 6 zu steuern, was über eine Einstellung einer an dem Anschlusspin 4c (Gate) und den Anschlusspin 4d (Sense) anliegenden Basisspannung in an sich bekannter Weise erreicht werden kann.

Falls der Feldeffekttransistor 6 beispielsweise infolge einer zu großen Basisspannung an den Anschlusspins 4c und 4d in den dauerhaft leitenden Zustand übergeht und somit durchschaltet, führt dies dazu, dass der Verbraucherstrom, der von einem an den Anschlusspins 4a und 4e angeschlossenen Verbraucher gezogen wird, nicht mehr eingestellt und gesteuert werden kann, was letztendlich zu einer Überhitzung des Feldeffekttransistors 6 mit den bereits zuvor geschilderten Folgen führen kann.

Um einer derartigen Überhitzung des Feldeffekttransistors entgegenzuwirken, umfasst das Feldeffekttransistorbauelement 2 die beiden pyrotechnischen Elemente 3a, 3b, mit welchen das Feldeffekttransistorbauelement 2 im Falle eines Ausfalls gezielt zumindest teilweise zerstört werden kann. Zwar sind hier zwei pyrotechnische Elemente 3a und 3b vorgesehen, jedoch reicht es prinzipiell zur Zerstörung des Feldeffekttransistorbauelements 2 durch gezielte Unterbrechung des von einem Verbraucher gezogenen Verbraucherstroms aus, lediglich ein pyrotechnisches Element 3b beispielsweise in der Verbindungsleitung 5 zwischen dem Source-Anschluss 7a und dem zugehörigen Anschlusspin 4a oder in der Verbindungsleitung 5 zwischen dem Drain-Anschluss 7e und dem zugehörigen Anschlusspin 4e vorzusehen, um auf diese Weise den Verbraucherstrom im Falle eines Ausfalls des Feldeffekttransistors 6 gezielt zu unterbrechen.

Die Aktivierung der pyrotechnischen Elemente 3a, 3b kann im Falle eines Ausfalls des Feldeffekttransistors 6 beispielsweise über einen externen Energieeintrag erfolgen, indem an den Anschlusspin 4ä gezielt eine Aktivierungsspannung angelegt wird, wodurch sich das pyrotechnische Element 3b und/oder das pyrotechnische Element 3a so stark erwärmt, dass dadurch die bereits zuvor erwähnte pyrotechnische Kettenreaktion ausgelöst wird, wodurch letztendlich die Verbindungsleitung 5 zwischen dem Anschlusspin 4a und dem Source-Anschluss 7a und/oder die Verbindungsleitung 5 zwischen dem Anschlusspin 4e und dem zugehörigen Drain-Anschluss 7e unterbrochen wird, so dass der Verbraucherstrom zum Erliegen kommt.

Die Steuerung des genannten externen Energieeintrags kann beispielsweise in Abhängigkeit der aktuellen Temperatur des Feldeffekttransistorbauelements 2 erfolgen, welche von geeigneten Temperaturfühlern überwacht wird. Die so ermittelte Temperatur kann dann von einer Auswerteinheit dahingehend beurteilt werden, ob die Temperatur über einem vorbestimmten Grenzwert liegt oder nicht. Liegt die Temperatur darüber, so kann anschließend von der Auswerteinheit der erforderliche Energieeintrag veranlasst werden, indem an zumindest einem der Anschlusspins 4a bis 4e eine elektrische Spannung angelegt wird.

Dadurch, dass das pyrotechnische Element 3a die vier Verbindungsleitungen 5 zwischen den Transistoranschlüssen 7b und 7e und den zugehörigen Anschlusspins 4b bis 4e miteinander in reaktiver Weise koppelt, werden durch die ausgelöste Kettenreaktion auch die Verbindungsleitungen 5 zwischen den Transistoranschlüssen 7b bis 7e und den zugehörigen Anschlusspins 4b bis 4e unterbrochen, so dass mit hoher Zuverlässigkeit das Feldeffekttransistorbauelement 2 in einen gesicherten Zustand überführt werden kann.

Anstelle die pyrotechnischen Elemente 3a und 3b über einen externen Energieeintrag zu aktivieren, kann die Aktivierung auch durch die entstehende Wärmeenergie erfolgen, welche durch den im Falle eines Ausfalls des Feldeffekttransistors 6 nicht mehr steuerbaren Verbraucherstrom in dem Feldeffekttransistorbauelement 2 freigesetzt wird, so dass dadurch das Feldeffekttransistorbauelement 2 selbsttätig in den gesicherten Zustand übergeht.

### Bezugszeichenliste

- 1: Gehäuse
- 2: Feldeffekttransistorbauelement
- 3a: pyrotechnisches Element
- 3b: pyrotechnisches Element
- 4a: Anschlusspin
- 4b: Anschlusspin
- 4c: Anschlusspin
- 4d: Anschlusspin
- 4e: Anschlusspin
- 5: gebondete Verbindungsleitungen
- 6: Feldeffekttransistor
- 7a: Source-Anschluss
- 7b: Massenanschluss
- 7c: Gate-Anschluss
- 7d: Sense-Anschluss
- 7e: Drain -Anschluss

## Patentansprüche

1. Feldeffekttransistorbauelement (2) mit einem Feldeffekttransistor (6) und zumindest einem reaktiven Element (3a, 3b), welches im Falle eines Ausfalls des Feldeffekttransistors (6) aktivierbar ist, um das Feldeffekttransistorbauelement (6) gezielt zumindest teilweise zu zerstören.

2. Feldeffekttransistorbauelement (2) nach Anspruch 1,
**dadurch gekennzeichnet, dass** der Feldeffekttransistor (6) derart eingerichtet ist, dass er infolge der zumindest teilweisen Zerstörung durch das reaktive Element (3a, 3b) in einen Leerlaufzustand übergeht.

3. Feldeffekttransistorbauelement (2) nach Anspruch 1 oder 2,
**dadurch gekennzeichnet, dass** das reaktive Element (3a, 3b) ein pyrotechnisches Element, eine chemisch reaktive Substanz und/oder eine reagierende Flüssigkeit umfasst.

4. Feldeffekttransistorbauelement (2) nach zumindest einem der vorstehenden Ansprüche,
**dadurch gekennzeichnet, dass** das reaktive Element (3a, 3b) innerhalb des Gehäuses (1) des Feldeffekttransistorbauelements (2) angeordnet ist.

5. Feldeffekttransistorbauelement (2) nach zumindest einem der vorstehenden Ansprüche,
**dadurch gekennzeichnet, dass** das reaktive Element (3a, 3b) derart lokalisiert ist, dass durch dessen Aktivierung die Verbindung (5) zwischen zumindest einem Anschlusspin (4a, 4b, 4c, 4d, 4d, 4e) des Feldeffekttransistorbauelements (2) und dem Feldeffekttransistor (6) unterbrochen wird.

6. Feldeffekttransistorbauelement (2) nach zumindest einem der vorstehenden Ansprüche,
**dadurch gekennzeichnet, dass** das reaktive Element (3a, 3b) im Verlauf zumindest einer Verbindung (5) zwischen dem Feldeffekttransistor (6) und einem Anschlusspin (4a, 4b, 4c, 4d, 4d, 4e) des Feldeffekttransistorbauelements (2) angeordnet ist.

7. Feldeffekttransistorbauelement (2) nach zumindest einem der vorstehenden Ansprüche,
**dadurch gekennzeichnet, dass** zumindest im Verlauf der Verbindung (5) zwischen dem Drain-Anschluss (7e) des Feldeffekttransistors (6) und dem zugehörigen Anschlusspin (4e) oder im Verlauf der Verbindung (5) zwischen dem Source-Anschluss (7a) des Feldeffekttransistors (6) und dem zugehörigen Anschlusspin (4e) ein reaktives Element (3a, 3b) angeordnet ist.

8. Feldeffekttransistorbauelement (2) nach zumindest einem der vorstehenden Ansprüche,
**dadurch gekennzeichnet, dass** im Verlauf sämtlicher Verbindungen (5) zwischen dem Feldeffekttransistor (6) und den Anschlusspins (4a, 4b, 4c, 4d, 4d, 4e) des Feldeffekttransistorbauelements (2) ein reaktives Element (3a, 3b) angeordnet ist.

9. Feldeffekttransistorbauelement (2) nach zumindest einem der vorstehenden Ansprüche,
**dadurch gekennzeichnet, dass** das zumindest eine reaktive Element (3a, 3b) eingerichtet ist, um durch einen externen Energieeintrag aktiviert zu werden.

10. Feldeffekttransistorbauelement (2) nach zumindest einem der vorstehenden Ansprüche,
**dadurch gekennzeichnet, dass** das zumindest eine reaktive Element (3a, 3b) eingerichtet ist, um im Falle eines Ausfalls des Feldeffekttransistorbauelements (2) durch die dabei freiwerdende Wärmeenergie aktiviert zu werden.
